# EUROPEAN PATENT SPECIFICATION

(11) **EP 3 931 366 B1**
(45) Date of publication and mention of the grant of the patent: **31.07.2024**
(21) Application number: 20706535.0
(22) Date of filing: 02.03.2020
(51) Int. Cl.: C23C 14/50, C23C 14/56, C23C 16/458

(54) **PROCESSING LINE FOR DEPOSITING THIN-FILM COATINGS**
VERARBEITUNGSLINIE ZUR ABSCHEIDUNG VON DÜNNSCHICHTBESCHICHTUNGEN
LIGNE DE TRAITEMENT POUR LE DÉPÔT DE REVÊTEMENTS DE FILM MINCE

(30) Priority: 01.03.2019 EP 19160257
(43) Date of publication of application: 05.01.2022
(73) Proprietor: The Batteries spólka z ograniczona odpowiedzialnoscia, 35-005 Rzeszów (PL)
(72) Inventor: KHISAMOV, Ayrat K., Ufa, 450004 (RU); ROSSOKHATY, Oleksandr, Westmount, Québec H3Z 1K8 (CA); KOROLENKO, Iaroslav, Zheleznogorsk, 662978 (RU)
(74) Representative: Jeck, Anton
(86) International application number: PCT/EP2020/055441
(87) International publication number: WO 2020/178238

(56) References cited:
- RU-C1- 2 507 308
- US-A1- 2016 333 467

## Description

### Field of the Invention

The invention relates to the field of mass production technological equipment for surface treatment, and particularly, to vacuum processing equipment intended for depositing thin-film coatings with specified optical, electrical and other characteristics.

### Prior art

From the prior art, various methods and installations for depositing thin-film coatings onto the treated products (substrates) are known.

A method and device for magnetron sputtering of thin-film coatings onto substrates are known (see [1] US 4,851,095, Int. Cl. C 23 C 14/00, publication date: July 25, 1989), in which said substrates are mounted onto the substrate support embodied in the form of a rotating cylindrical drum. The sputtering of the coatings onto the substrates is carried out by the working devices located within a vacuum chamber surrounding the drum. The uniformity of the coating in one direction is ensured by rotating the drum, and in the second direction - by using linear technological devices.

The disadvantages of such technical solution include low productivity and considerable cost of the products dictated by the necessity to repeat the processing operations in order to achieve the required number of layers within the structure.

Another method and processing line for depositing thin-film coatings are known (see [2] US 6,893,544, Int. Cl. C 23 C 14/34, publication date: May 17, 2005). The method consists in placing the substrates on a flat vertical carriage-carrier moving within a linear-type technological device. In this case, the processing line includes positioned in series lock-chamber, processing chamber containing the technological device, outlet buffer chamber and a flat substrate support capable of moving along the chambers.

The disadvantages of this technical solution include:
- limited range of standard sizes of the treated substrates, and particularly, inability to process flexible substrates, such as thin glass, due to inability to ensure secure attachment and safety thereof when moving along the processing line;
- high cost resulting from the use of complicated control and adjustment systems, especially in case of complex and precision coatings, as well as significant consumption of the deposited material, 30 to 50% of which are sprayed outside of the substrate to ensure uniformity of the deposited layer due to making the processing zone of the technological device larger than the uniformity zone, which also results in low productivity;
- limited variety of applicable technologies and technological devices, since the potential application is limited by the requirements to acceptable uniformity of the deposited layer.

An in-line type equipment is known from the prior art, which is used to treat flat substrates. For example (see [3] Russian Federation utility model patent No. 78785, Int. Cl. B 82 B 3/00, publication date: December 10, 2008), an automated setup for forming thin-film coatings of nanosized thickness by using a molecular layering method is known, where substrates are mounted onto the carriage-carrier, which moves along the processing stages arranged in series. However, this device, same as current in-line type equipment, has disadvantages, which include low operational reliability caused by the fact that secure attachment of the substrates depends on how smooth the transport system is, and high cost associated with the use of complicated control and adjustment systems to ensure the required uniformity of the deposited coatings.

Most of the above-specified disadvantages of the analogs were resolved in the RF patent No. 2507308, used as a prototype. In the closest analog, a method for depositing thin-film coatings is described (see [4] Russian Federation patent No. 2507308, Int. Cl. C 23 C 16/54, C 23 C 14/56, publication date: February 20, 2014) comprising placement of substrates on the supports embodied in the form of rotating drums, and sequential movement of the supports with attached substrates through the processing chambers, in which the coatings are deposited by means of the technological devices located inside the processing chambers, wherein the drums are moved through the processing zones of the technological devices in the direction parallel to their rotation axis while rotating at the constant linear and angular velocities, in which case the linear-to-angular velocity ratio is selected based on the condition that each point of the drum surface should make at least two full revolutions when passing through a processing zone of the technological device. This method is implemented in the processing line for depositing thin-film coatings comprising lock and buffer chambers, and at least one processing chamber containing a technological device; substrate supports located on the carriages capable of passing sequentially through the chambers; and a transport system, wherein each substrate support is embodied in the form of a rotating drum installed on the carriage coaxially to the movement direction thereof, while the drums are configured to rotate at a constant angular velocity and carriages are configured to move at a constant linear velocity while ensuring that each point of the drum surface will complete at least two full revolutions when passing through a processing zone of the technological device.

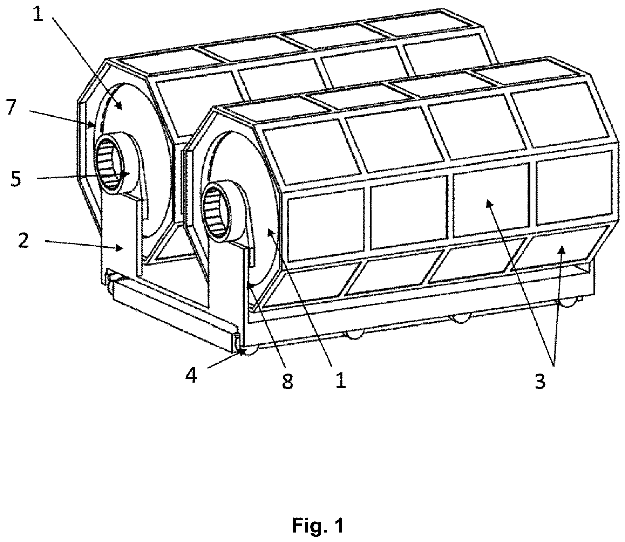

A disadvantage of the prototype is that some technological devices, which can be located inside the processing chamber, and particularly, evaporators, which can constitute a considerable part of these technological devices, cause an inefficient consumption of the material precipitating onto the substrates in the form of the required thin-film coatings. A part of the material precipitates onto the walls of the chamber and other elements. As an example, it is possible to consider an evaporator embodied in the form of a crucible containing the material for precipitation. Regardless of the method of heating of the crucible and/or the material inside the crucible, precipitation of the film on the substrate located in front of the crucible will follow the cosine law (see [4] Fig. 1). A part of the evaporated material will miss the substrate.

US 2016/333467 discloses a processing line for depositing thin-film coatings comprising at least one lock chamber, at least one buffer chamber and at least one processing chamber containing technological devices, as well as a substrate support located on carriages configured to pass sequentially through the chambers, wherein 1 of the technological devices is adapted to deposit material on the surface of the substrate and one further device is adapted to further process the deposited material, the substrate holder are made as the rotating drum which moves through the processing chamber parallel to the rotation axis of the drum.

The objective of the proposed invention is to eliminate the disadvantages of the analogs and prototype by creating a high-performance equipment, capable of depositing onto substrates complex coatings, such as metal-dielectric and composite metal-dielectric coatings.

Technical result of the proposed invention consists in increased productivity and efficiency of material consumption when precipitating thin-film coatings, as well as in possibility of implementing various schemes of depositing thin-film coatings in one line.

The above task is solved, and the technical result is achieved by proposing a processing line for depositing thin-film coatings as disclosed in the appended claims.

The technological device may be e.g. a source of depositing material such as vaporizers or preferably in the form of a magnetron or any other source of e.g. mist, vapor or spirited particles as layering material.

The technological device may also be e.g. any curing and/or hardening and/or drying device such as a high density plasma source, means for oxidation of deposited material on the surface including any means that lead to a formation of a chemical compound including reaction with e.g. oxygen, nitrogen, selenium. Thus, the technological device may be any means that as necessary for applying or curing or participating in the formation of deposited layer structure on a treated surface.

### Description of the drawings

- Fig. 1: shows an isometric view of two substrate supports mounted on one carriage,

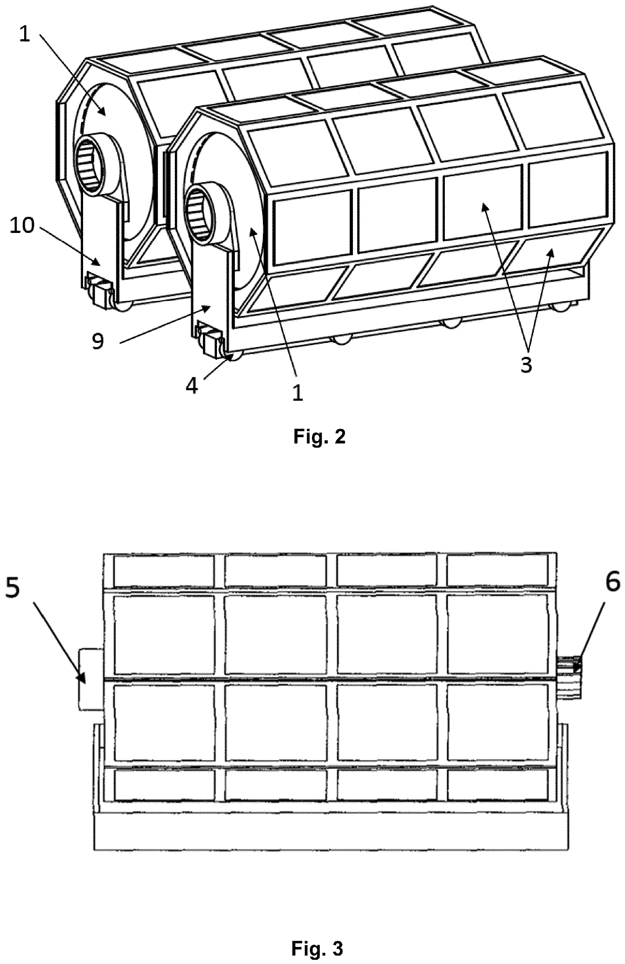

- Fig. 2: shows an embodiment, in which the carriages with one substrate support on each carriage are installed parallel to each other,
- Fig. 3: shows a frontal view of the substrate support,

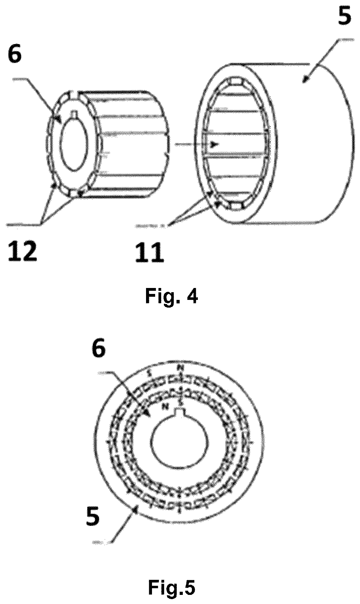

- Fig. 4: shows an isometric view of the magnetic coupling elements,
- Fig. 5: shows a frontal view of the magnetic coupling,

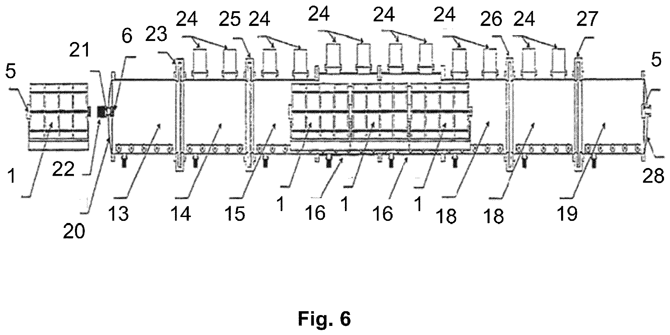

- Fig. 6: shows an overall diagram of the processing line,
- Fig. 7: shows a schematic of placing an evaporator/magnetron under the drums, and a plasma source - above the drums,
- Fig. 8: shows a schematic of placing several evaporators/magnetrons with the same of different materials under the drums, and a plasma source - above the drums,
- Fig. 9: shows a schematic of placing an evaporator/magnetron with the first material under the drums, and a magnetron with the target made of the second material - above the drums,
- Fig. 10: shows a schematic of placing an evaporator/magnetron with the first material under the drums, a magnetron with the target made of the second material - above the drums, and a plasma source - to the side of each drum.
- Fig. 11: shows a schematic of placing an evaporator/magnetron with the first common material under the drums, a magnetron with the target made of the second common material - above the drums, and a magnetron with the target made of an individual material for each drum - to the side of the drum
- Fig. 12: a setup with two sources of depositioning material of identical or different material on one side of the drum and a technological device for further processing on the other side of the drum.

The positions on the drawings are marked as follows:
1 - substrate support;
2 -carriage for two drums;
3 - substrates;
4 - carriage guides;
5 -first element of the detachable magnetic coupling;
6 - mating element of the detachable magnetic coupling;
7 - electric drive rotor;
8 - electric drive stator;
9 - carriage for the first drum;
10 - additional carriage for the second drum;
11 - magnets of the first element of the detachable magnetic coupling;
12 - magnets of the mating element of the detachable magnetic coupling;
13 - low-vacuum inlet lock-chamber;
14 - high-vacuum inlet lock-chamber;
15 - inlet buffer chamber;
16 - processing chamber with technological devices installed therein;
17 - outlet buffer chamber;
18 - high-vacuum outlet lock-chamber;
19 - low-vacuum outlet lock-chamber;
20 - low-vacuum lock-chamber door;
21 - shaft of the vacuum rotary-motion feedthroughs of the motor;
22 - electric motor;
23 - transport lock;
24 - turbomolecular pump;
25 - transport lock;
26 - transport lock;
27 - transport lock;
28 - low-vacuum lock-chamber door;
29 - evaporator or magnetron;
30 - plasma source;
30' - plasma from plasma source
31 - evaporator or magneton with the first material;
32 - magnetron with the target from the second material;
33 - magnetron with the target from the required material.
34 - deposition material from the technological equipment (magnetron, evaporator,...)

### Detailed Description of the Embodiments

To achieve the above objective and eliminate the disadvantages of the prototype and analogs, several embodiments of the processing line for depositing thin-film coatings onto substrates are proposed.

In the proposed invention, several methods of installing the drums onto the carriages and moving them through the lock, buffer and processing chambers were used (note that there can be more than one chamber of each specific type):
- installing two carriages next to each other, i.e., substantially in parallel, while installing one or two drums on each carriage, and moving them forward in the opposite directions (towards each other);
- installing two carriages next to each other, i.e., substantially in parallel, while installing one or two drums on each carriage, and moving them forward in the same direction.

**According to the first** setup, the proposed processing line comprises at least one lock-chamber, at least one buffer chamber, and at least one processing chamber containing technological devices, as well as substrate supports, and a transport system with drive rollers and high-vacuum pumps.

Substrate support (1) is embodied in the form of a rotating drum installed in the bearings on carriage (2). The carriages are configured to pass from one chamber to another. However, within a chamber, in particular within the processing chamber the at least one carriage can be moved at a constant speed from one end of the chamber to the opposite end. According to figure 1, two rotating drums are mounted next to each other on each carriage, so that their axes are parallel, i.e. the drums are installed in such a way that the generator lines thereof are parallel. A so-formed pair of drums is installed on the carriage coaxially to its moving direction and is preferably configured to rotate at a constant angular velocity, while the carriages are configured to move forward at a constant linear velocity. This may ensure that each point of the drum surface will complete at least two full revolutions when passing through a processing zone of the technological devices. The drums may have the same or different diameter. Additionally, the drums are capable of rotating in the same or opposite directions. The drums are positioned in such a way that the distance between their axes is equal to the sum of radiuses of the drums, while ensuring a minimum clearance between them. Several carriages can be moved together through the chamber wherein the carriages are e.g. aligned parallel to each other or behind each other.

Substrates (3) are preferably mounted to the drum surface by any known method of securing them reliably during the rotation and movement of the drums. The carriage is provided with guides (4) installed on the posts (not shown of the drawing) made of a dielectric material. The carriage guides are installed on the drive rollers of the transport system.

To achieve a continuity of the process, preferably the carriages with the drums move through the chambers sequentially, thus one after another.

On the ends of a shaft of each drum, elements (5) and (6) of the detachable magnetic coupling can be installed. The configuration of the coupling is well-known. The first element of the detachable coupling (5) represents a hollow cylinder made of a soft magnetic material with magnets (11) mounted on the internal surface thereof. The magnets are installed with alternating polarity in the directions of magnetization shown in the drawing. The mating element (6) of the magnetic coupling represents a cylinder made of a soft magnetic material with magnets (12) mounted on the surface thereof, the number of which matches the number of the magnets of the first element. The magnets are installed with alternating polarity in the directions of magnetization shown in the drawing. There is a 5 mm gap between the magnets of the first (5) and mating (6) elements to ensure no touching when the coupling slips due to an imprecise joining of the substrate supports (1).

To maintain the drum rotation at a constant angular velocity, preferably a direct-acting electric drive is used. The rotor of electric drive (7) is preferably formed by a ring-type magnetic circuit with magnets mounted thereon. The stator of electric drive (8) and the control unit are mounted on the carriage frame. The electric drive is powered by direct current supplied through the linear guides of carriage (4). For this purpose, the linear guides are secured on the isolating posts of the carriage. The power to the linear guides is fed through the rollers of the transport system.

The technological devices are preferably installed along the path of the substrate supports, and the processing zone is defined as the area along the path of the substrate supports, within which the technological device is located, and within which the majority of the material deposited by this device (above 90%) hits the substrate support. In this case, several technological devices intended for depositing the same material, which form partially or completely overlapping processing zones, are considered as one technological device. If necessary, several technological devices participating in depositing a layer can be installed around the substrate supports thus, around the drums along their movement path within the processing chamber. Technological devices for depositing materials can also be realized in the form of evaporators, electron beam evaporators (EBE), magnetrons, ionic sources and any other known technological devices especially for deposition of coating material.

Preferably, the processing line comprises at least one lock-chamber, at least one buffer chamber, and at least one processing chamber containing technological devices; as well as preferably substrate supports and/or a transport system with drive rollers and/or high-vacuum pumps.

According to a setup of the invention, substrate support (1) is embodied in the form of a rotating drum which is installed in the bearings on carriage (9). Parallel to the moving direction of the carriage, an additional second carriage (10) is installed with one rotating drum mounted on each carriage. Each drum is installed on a carriage coaxially to its moving direction and is configured to rotate at a constant angular velocity, while the carriages are configured to move forward at a constant linear velocity while preferably ensuring that each point of the drum surface will complete at least two full revolutions when passing through a processing zone of the technological devices. The drums are preferably positioned in such a way that the distance between the axes thereof is equal to the sum of radiuses of the drums, while ensuring a minimum clearance between them such that the drums do not touch each other. Additionally, the drums are preferably capable of rotating in the same or opposite directions.

Substrates (3) are mounted to the drum surface by any known method of securing them reliably during the rotation and movement of the drums. The carriage is provided with guides (4) installed on the posts (not shown of the drawing) made of a dielectric material. The carriage guides are installed on the drive rollers of the transport system.

Carriages that are installed/arranged next to each other, i.e., substantially in parallel, are configured to move forward in the same or opposite directions, i.e., towards each other, e.g. on individual tracks for each carriage.

The tracks might also be connected e.g. such that on one track a carriage(s) might move in one direction through the processing zone and on the other track the carriage might move on the other track in the opposite direction though the processing zone.

The two track may also be embodies as a single track that is bent or redirected such that at least two parts of the track are oriented parallel to each other.

A carriage moving along such track has at least twice the movement distance within the processing zone compared to a single movement though the processing zone which allows for much more surface treatment which in the same length of a processing zone.

Also, such setup allows to pass through the processing zone more than one carriage at a time even with only one airlock on one side of the processing zone since the way into the processing zone and out of the processing zone are preferably provided on separate tracks or separate parts of the track.

Accordingly, the inventive setup allows for a much higher throughput of carriag-es/drums even with only one airlock/opening compared to a setup known in the prior art.

To achieve the continuity of the process, the carriages with the drums move through the chambers preferably sequentially, thus one after another. The drum rotation, is preferably performed by direct-acting electric drive powered through the linear guides of the carriage.

The technological devices are installed along the path of the substrate supports and/or the processing zone is defined as the area along the path of the substrate supports, within which the technological device(s) is located, and within which the majority of the material deposited by this device (above 90%) hits the substrate support. In this case, several technological devices intended for depositing the same material, which form partially or completely overlapping processing zones, are considered as one technological device. If necessary, several technological devices participating in depositing a layer can be installed around the substrate supports. Technological devices for depositing materials can be realized in the form of evaporators, electron beam evaporators (EBE), magnetrons, ionic sources and any other known technological devices.

In a number of cases, depending on applicable technological process, the carriage can be embodied:
- in the form of a cart, when linear guides are located under the drum;
- in the form of a suspension, when the linear guides are located above the drum;
- in the form of a frame, when the linear guides are located on the different sides of the drum;
- or in any other manner, which provides the possibility of linear movement of the rotating drum.

The line may operate as follows.

Supports (1) with the substrates mounted thereon are supplied to a low-vacuum inlet lock-chamber (13), after which the lock-chamber door (20) is closed. After the door closing, the supports may be moved back, and their detachable couplings (5) may engage with the mating parts of the couplings (6) mounted to the shafts of the vacuum rotary-motion feedthroughs of the motors (21) which may be installed on the lock-chamber door and/or be activated by the electric motors (22). In this case, it is possible to use a single electric motor, or several electric motors, one per each shaft.

The electric motor spins up the substrate supports to a preset rotation velocity, while the lock-chamber is being evacuated to 10-20 Pa.

After evacuating the low-vacuum inlet lock-chamber and spinning up the drums, the transport lock (23) opens, the carriage carriers move to the high-vacuum inlet lock-chamber (14), and the lock (23) is closed. The high-vacuum lock-chamber may be provided with turbomolecular pumps (24), and maybe evacuated to < 0.01 Pa. To equalize the pressure between the lock-chamber and processing chamber, a controlled filling of the lock-chamber with gas of controlled composition can be used, while monitoring the pressure level and ensuring its equality to the pressure inside the processing chamber is possible.

Once the high-vacuum lock-chamber is pumped down, the transport lock (25) may open, the substrate supports may move to the inlet buffer chamber (15), and the lock (25) may be closed. In the buffer chamber, the substrate supports may be slowed down to the processing velocity value and may be joined with the substrate supports supplied to the processing line at the previous step. The magnetic couplings of the substrate supports may engage, and rotation of the supplied substrate support may be synchronized with that of substrate supports (1) passing through the processing chamber. In the processing chamber, the rollers of the transport system may be energized, so that electric motors of the substrate supports can sustain rotation of their drums.

When passing through the processing chamber(s) (16), the coating is deposited onto the substrates. While the substrates are being treated (when passing through the processing zone), the drums may rotate and may move steadily along their axes. The substrate supports preferably move through the processing zones at a minimum clearance between them.

Considering that the uniformity is preferably determined by a displacement pitch during one revolution, the ratio between the linear movement velocity and rotation velocity of the substrate supports is preferably set such that each point of the surface of the substrate supports would complete at least two full revolutions when passing through the processing zone. Hence, the displacement pitch during one revolution is preferably rather small and allows providing high uniformity of the deposited coatings regardless of the utilized types of technological devices, including linear and point-type devices.

The objective of ensuring the required rotation velocity of the substrate supports during processing while maintaining concurrent linear movement can be achieved by one of the following methods:
1. Substrate supports are spun up to the required velocity value by an external drive in one of the inlet chambers while the carriage stays in place, and then continue spinning by inertia.
2. Each carriage is provided with a low-voltage electric motor. The power to the motor is supplied through the rollers of the transport system or through the separate contact rollers to the linear carriage guides isolated from the housing of the carriage.
3. Substrate supports are spun up to the required velocity value by an external drive in one of the inlet chambers while the carriage stays in place, in which case the carriage is provided with a low-voltage electric motor, which is used only for supporting rotation and can be of a very small capacity.

To ensure equal rotation velocity of all substrate supports in the processing zone, they can be provided with friction- or magnetic-type detachable couplings facilitating a transfer of rotation between adjacent substrate supports moving at a minimum clearance.

In order to deposit metal-dielectric and composite metal-dielectric coatings, in addition to conventional devices for in-line equipment, one of the following methods can be used, namely, multiple deposition of thin metallic or unoxidized layers with subsequent oxidation.

In this case, oxidation means any reaction leading to the formation of a chemical compound, including reactions with oxygen, nitrogen, selenium, etc.

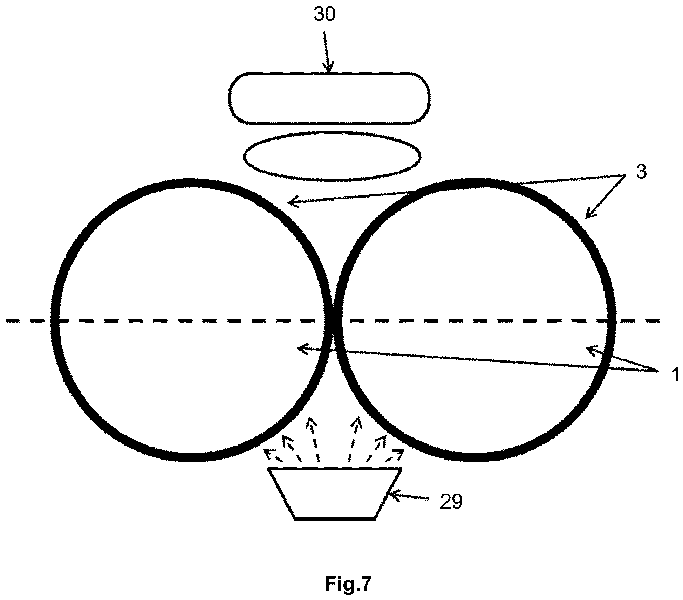

To achieve this, a special processing zone is formed, within which the substrate support is surrounded by the technological devices for depositing one or several metals, and a technological device for performing oxidation, which represents a source of activated jet gas (for example, a plasma source, wherein the source can be any known plasma-generating device) (Fig. 7-11). In such a case the technological devices for depositioning of the material on the surface (on/of the drum) to be layered may be located within the processing zone such that one side of the drum/carriage passes by that technological device e.g. on the bottom part of said processing zone. Other technological devices for e.g. hardening, curing or oxidation of the depositioned material may be located within the processing zone such that the opposite side of the drum compared to the side of the drum that is oriented towards the technological devices for depositioning of the material on the surface to be layered is treated. Thus, the devices may be provided on opposite sides withing the processing zone.

Such technological device may be e.g. located in a top part of said processing zone, preferably above the drums which passes by said technological devices.

Consequently, a 1^{st} side of the drum surface, preferably along a longitudinal axis of the drum, is orientated towards technological devices for depositioning and a 2^{nd} side of the drum surface, preferably also along a longitudinal axis of the drum, is orientated towards technological devices for further treatment e.g. hardening, curing or oxidation of the depositioned material.

It is clear that the terms 1^{st} and 2^{nd} side of the drum surface is a rather dynamic definition since the drum is preferably constantly rotating within the processing zone. However, at each point and time there's two opposite sides of the rotating drum whereby each side is orientated towards 1 of the 2 preliminarily explained technological devices. One could also define, that the drum is passed through a processing zone within the processing chamber wherein the processing zone is defined by at least 2 technological devices which are located such that a rotating drum passing through that processing zone will be treated by those technological devices from different angles but preferably simultaneously. This angle between the devices along a longitudinal axis of movement of the carriage/drum within the processing chamber may be 180° thus treatment from opposite sides. However, treatment may also be provided from a different angle e.g. 120°, 90° or 60° when more than one depositioning device or device for further treatment of the depositioned layer is provided. In such a case the orientation of the technological devices can rather be in the form of a triangle, square, pentagon or any regular or irregular geometrical arrangement through which the rotating drum passes.

In the processing zone, high-vacuum evacuation equipment may be installed to ensure gas separation between the technological device for performing e.g. oxidation and technological devices for e.g. depositing materials. This provides a stable and high-performance operation of the technological devices for depositing materials. generally, that gas separation between the technological devices can be provided between all technological devices. Preferably the gas separation is provided between the means for depositioning of coating material and the means for processing the depositioned material on the surface of the drum.

When passing through this processing zone, each point of the processed surface sequentially may pass multiple times by the technological devices for depositing materials, where a super-thin layer of material is deposited, and by the technological device of performing e.g. oxidation, where this layer is preferably completely oxidized of further treated (cured, hardened,...) in another suitable way. After passing through the processing zone, the treated surface becomes evenly coated with metal-dielectric or composite metal-dielectric coating having a specified composition.

Technological devices can deposit same or different materials. In the latter case, the rates of material deposition can be set to be different to ensure the required composition of the coating.

After passing through the processing chambers (16), the substrate supports exit into the outlet buffer chamber (17).

The transport lock (26) may open, substrate supports may accelerate accelerated while preferably increasing the distance from the supports that follow, and move to the high-vacuum outlet lock-chamber (18). After this, lock (26) preferably closes, transport lock (27) preferably opens, and the substrate supports move to the low-vacuum outlet lock-chamber (19), where the mating elements of the magnetic couplings of the substrate supports may be joined with the first elements of magnetic couplings (5) mounted on a door. The elements of magnetic couplings (5) may be secured on the shafts, the rotation of which is inhibited due to friction.

The lock (27) closes, the chamber is filled with dried air, and the pressure rises to atmospheric. At this time, due to braking of the coupling (5), the drums of the substrate supports come to a stop.

Once the pressure in the outlet lock-chamber (19) reaches atmospheric, preferably the chamber door (28) opens, and the substrate support comes out of the processing line.

The drums are preferably configured to facilitate a concentric rotation of the substrates or flipping of the substrates in one or several given positions along the processing line.

The described sequence of line operation is applicable to all drum installation options on the carriages.

In addition, a modification of the line, which has no outlet lock and buffer chambers, is possible, which can be achieved by installing e.g. two carriages next to each other, i.e. substantially, in parallel, and moving the carriages forward in e.g. opposite directions (towards each other) e.g. on separate tracks so they can pass by each other

The inlet lock-chamber may also be used as an outlet chamber, i.e., the carriages carrying substrates mounted to the drums move until the end of the processing chamber, and then may turn around (preferably switched to a counter path) and go back to the lock-chamber. Turning around of the carriages (e.g. switching them to a counter path) may be performed without exposure to the atmosphere. Due to such realization of the invention, it becomes possible to reduce the number of chambers in the system, and also save place inside the clean room. in case the drums move towards each other, it is possible to deposit several coatings, i.e., when moving in one direction, one coating is deposited, and when moving in the reverse direction, another coating can be deposited.

Also, when the drums move towards each other, it is possible to deposit coating onto both sides of the substrate, i.e., when moving in one direction, the coating is deposited to side A, and when moving in the reverse direction, the coating is deposited to side B. For this purpose, it can be possible to turn or flip the layers to be coated on the drum surface. Preferably, the drums may be configured to allow concentric rotation of the substrates or flipping of the substrates in one or several given positions along the processing line to deposit coatings onto both sides of the substrate.

The proposed (two-drum) system also allows realizing schemes for depositing complex single- and multi-component coatings in a single or multiple layers, including coatings in which different layers have different compositions, structure and properties, by utilizing different arrangement of the technological devices in the processing chamber.

A technological device for depositioning of layering material, e.g. an evaporator or magneton (29) is preferably positioned at the bottom of the processing chamber such that the carriage which moves by is orientated such that the technological device is located between the drums, while the technological device for further processing of the depositioned layer e.g. the plasma source (30) is positioned e.g. at the top the processing chamber such that the carriage which moves by is orientated (relative orientation) such that the technological device for the processing is located between the drums (Fig. 7). Such arrangement allows for a much higher depositioning yield with respect to the e.g. evaporated material compared to known setups. Especially a combination of a localization of the depositioning material source between the drum(s) significantly increases the percentage of e.g. vaporized material that depositions on the surface to be layered. In this case, any known e.g. plasma-generating device can be used as a technological device for further processing of the depositioned layer. Several e.g. evaporators and/or magnetrons can be installed along the processing chamber also in different angles with respect to the carriage with the drums passing by. They may contain the same or different materials to form composite or multilayer coatings. Two or more technological devices for depositioning of a layer material may also be provided at different angles in the same or different (longitudinal) position along the travelling route of the carriage within the processing chamber.

A quartz monitoring head may be placed next to the evaporators. The processing zone may be divided in such a way that the mutual effect of the reactive zone (further processing of the depositioned material) and material deposition zone could be eliminated, even if they are provided in the same (longitudinal) position along the chillout travelling route of the carriage within the processing chamber.

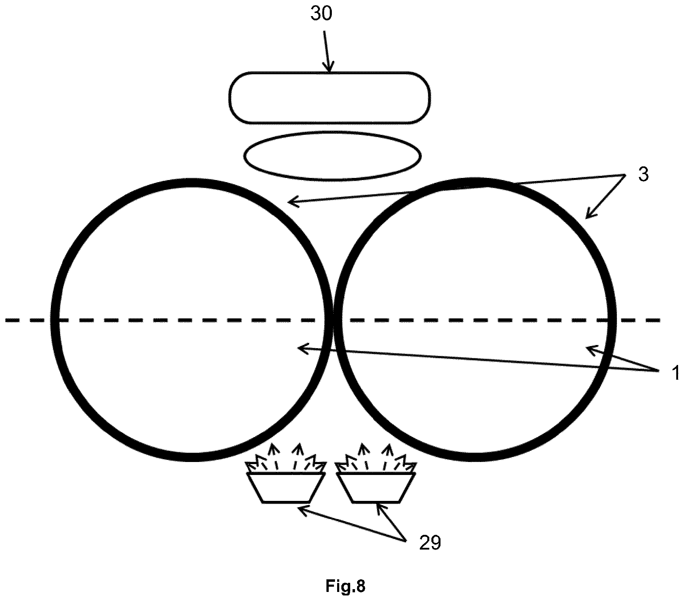

Two evaporators and/or magnetrons (29), may be located close to each other and containing different materials for depositing coatings with highly uniform composition and thickness, are positioned at the bottom between the drums, while the plasma source (30) may be positioned at the top between the drums (Fig. 8).

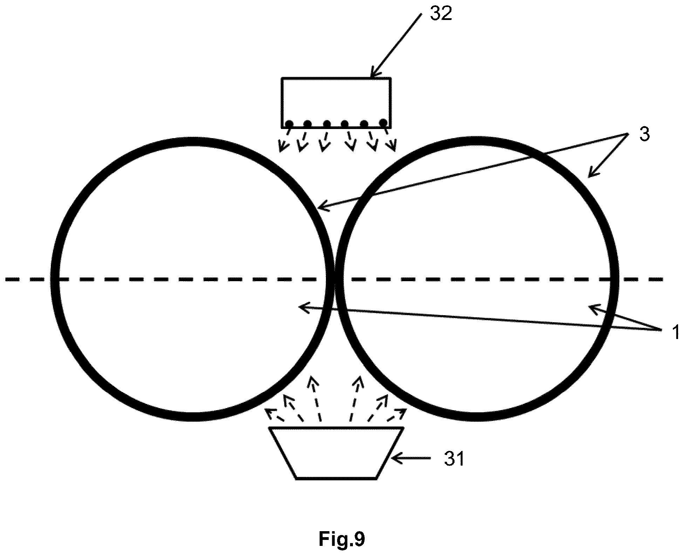

Evaporator or magneton (31) containing the first material may be positioned at the bottom between the drums, while a magnetron containing a target from the second material (32) may be positioned at the top between the drums (Fig. 9).

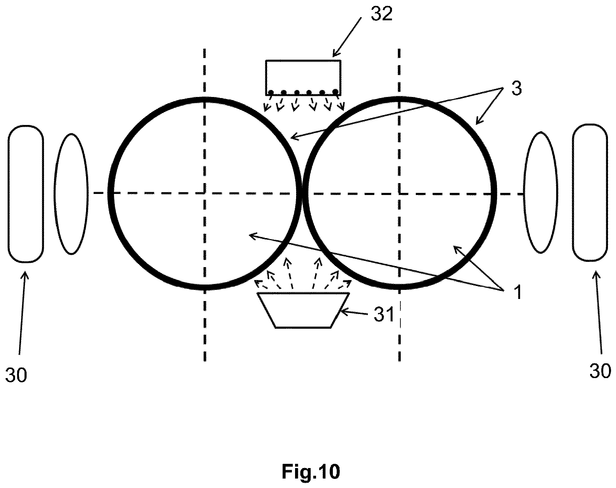

Evaporator or magneton (31) containing the first material may be positioned at the bottom between the drums, while a magnetron containing a target from the second material (32) may be positioned at the top between the drums. In this case, each drum may be provided with its own plasma source (30), for example, next to the drum (Fig. 10).

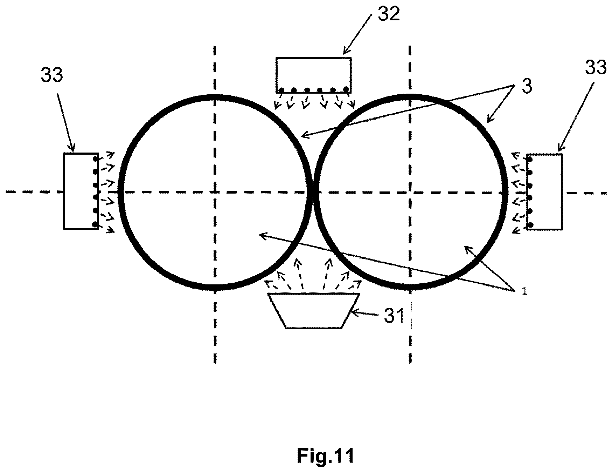

Preferably, at least one evaporator or magneton (31) containing the first common material is positioned at the bottom between the drums as described above, while at least one magnetron containing a target from the second common material (32) may be positioned at the top between the drums as described above . In this case, each drum may additionally be provided with their own magnetron containing a target from the required material (33), which is positioned, for example, next to the drum (Fig. 11).

Depending on the utilized technology, the set of technological devices may include similar technological devices with identical or different materials, or different technological devices with identical or different materials.

The above-described deposition schemes are provided as an example, and do not limit the field of the patent or its application: the specified examples can be used to create other schemes realizing similar principles and ideas. Also, it is important to note that the proposed invention allows for the use of different technological devices and combinations thereof. Thus, such devices as evaporators, electron beam evaporators (EBE), magnetrons, ionic sources and any other known technological devices can be used as technological devices for depositing materials. Also, plasma sources, ionic sources, lamps, lasers and any other known plasma-generating devices can be used as technological devices for surface treatment. For all types of technological devices, high uniformity of coating and high material collection coefficient can be provided by using the proposed design of the processing line.

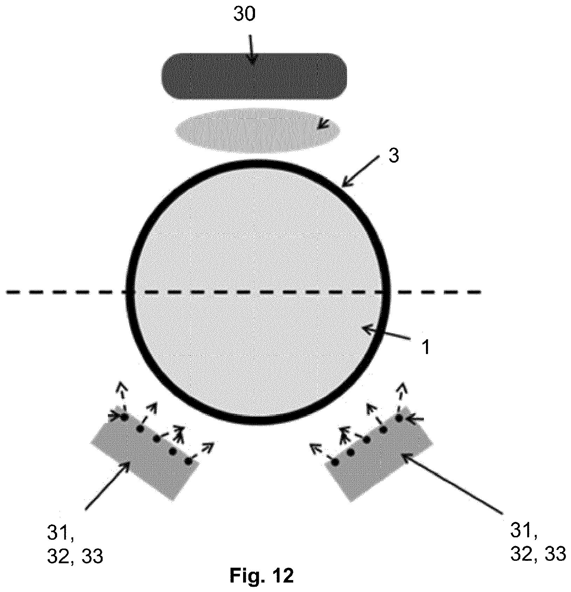

Figure 12 shows a processing line with details on the relative orientation of individual technological devices such as equipment for depositioning of surface layering material as e.g. a magnetron or an evaporator for depositioning of metals, alloys, silicon, polymers or different materials with respect to the rotating drum that passes by those individual technological devices.

The moving direction of the drum on the carriage defines a canal which is surrounded e.g. by the processing chamber of the processing line.

As outlined before, a gas separation installation might be provided which hinders material from the depositioning technological devices to enter a zone in which further processing of the depositioned material on the surface takes place. The processing zone can comprise e.g. a high-density plasma source which for example contains oxygen ions for oxidation of the layer material on that drum surface or any other above mentioned further processing installation.

That gas separation installation might divide the canal defined by the moving direction of the drum into at least 2 longitudinal compartments. Such compartments might be provided in the top half and the bottom half of the processing chamber and might extend or a portion or the whole length of the processing chamber. With an according installation of multiple gas separation installations, more compartments are possible to be provided.

In one of those compartments according to figure 12 at least one technological device for depositioning of layering material is provided. Preferably two of these sources are provided with in one compartment. The two technological devices, e.g. embodied as magnetrons, may provide similar identical or different depositioning materials.

Since the drum(s) rotating during the depositioning process the 1^{st} source provides for 1^{st} layer on that drum surface and the 2^{nd} source provides for 2^{nd} layer on the drum before the further processing in the 2^{nd} compartment via the technological devices for further processing, e.g. in the form of a high density plasma, is provid-ed/conducted.

Between the 1^{st} and 2^{nd} source of depositioning material further gas separation installation might be provided such that there is no intermixture of the material within the gas phase around the drum and consequently enhancing a clean depositioning of individual materials from the two individual sources.

Such setup might also be provided with a multitude of depositioning material sources and further processing installations whereby each technological device might be provided in a separate compartment divided by the individual gas separation installations.

The separation of technological devices might especially be useful in between the individual depositioning material sources, whereby further processing of the depositioned layer by more than one technological device might also be performed within a single together compartment.

## Claims

1. A processing line for depositing thin-film coating comprising at least one lock-chamber, at least one buffer chamber, and at least one processing chamber containing technological devices for depositing of layering material and for further processing of the depositioned layer, as well as two substrate supports (1) supporting substrates which substrate supports are located each on one carriage (9, 10) configured to pass through the chambers in parallel and next to each other, at least one technological device is adapted to deposit material on a surface of the substrate and at least one further device is adapted to further process the depositioned material on the substrate surface and
a transport system with each substrate support (1) embodied in the form of a rotating drum,
*wherein* the carriages (9, 10) each have a rotating drum oriented parallel to each other and mounted thereon and the arranged drums are installed on the carriages (9, 10) coaxially to the carriage's movement direction and are configured to rotate at a constant angular velocity, and the carriages (9, 10) are movable forward at a constant linear velocity wherein the technological device for depositing of layering material is located between the drums and the technological device for further processing of the depositioned layer is located between the drums.

2. The processing line according to claim 1, *wherein* the drums are configured to turn the orientation of the substrate (3) with respect to an outer surface of the drum in one or several positions of the carriage along the processing line.

3. The processing line according to claim 1, *wherein* the carriages (9, 10) are configured to move in one direction with respect to the processing line, in particular within the processing chamber.

4. The processing line according to claim 1, *wherein* the carriages (9, 10) are configured to move in opposite directions with respect to the processing line, in particular within the processing chamber.

5. The processing line according to claim 1, *wherein* at an end of the processing line the carriages (9, 10) are switchable or shiftable or exchangeable or changed or movable to a counter path without being exposed to the atmosphere.

6. The processing line according to claim 5, wherein the counter path is a path along which the carriages are individually moved in a first direction before being switched or shifted or exchanges ore moved to.

7. The processing line according to claim 5, wherein the counter path is oriented parallel to a first moving direction of the carriages (9, 10)

8. The processing line according to claim 5, wherein the first moving direction of the first carriage is the counter path for the second carriage and the other way around.

9. The processing line according to claim 1, *wherein* the drums on the carriage (9) and the additional second carriage (10) are configured to rotate in the same or opposite directions.

## Patentansprüche

1. Bearbeitungslinie zum Aufbringen einer Dünnschichtbeschichtung mit mindestens einer Schleusenkammer, mindestens einer Pufferkammer und mindestens einer Verarbeitungskammer, die technologische Vorrichtungen zum Aufbringen von Schichtmaterial und zur Weiterverarbeitung der aufgebrachten Schicht , sowie zwei Substratträger (1) enthält, die Substrate tragen, wobei die Substratträger jeweils auf einem Wagen (9,10) angeordnet sind, die dazu ausgebildet sind, die Kammern parallel und nebeneinander zu durchfahren, wobei mindestens eine technologische Vorrichtung dazu ausgebildet ist, Material auf einer Oberfläche des Substrats abzuscheiden und mindestens eine weitere Vorrichtung dazu ausgebildet ist, das abgeschiedene Material auf der Substratoberfläche weiter zu bearbeiten und
ein Transportsystem, bei dem jeder Substratträger (1) in Form einer rotierenden Trommel ausgeführt ist,
wobei die Schlitten (9, 10) jeweils eine parallel zueinander ausgerichtete und daran befestigte rotierende Trommel aufweisen und die angeordneten Trommeln auf den Schlitten (9, 10) koaxial zur Bewegungsrichtung des Schlittens installiert und so ausgebildet sind, dass sie mit einer konstanten Winkelgeschwindigkeit rotieren, und die Schlitten (9, 10) mit einer konstanten linearen Geschwindigkeit vorwärts bewegbar sind, wobei sich zwischen den Trommeln die technologische Einrichtung zum Aufbringen von Schichtmaterial und zwischen den Trommeln die technologische Einrichtung zur Weiterverarbeitung der aufgebrachten Schicht befindet.

2. Bearbeitungslinie nach Anspruch 1, *wobei* die Trommeln so konfiguriert sind, dass sie die Ausrichtung des Substrats (3) in Bezug auf eine Außenfläche der Trommel in einer oder mehreren Positionen des Wagens entlang der Verarbeitungslinie drehen.

3. Bearbeitungslinie nach Anspruch 1, *wobei* die Schlitten (9, 10) so konfiguriert sind, dass sie sich in einer Richtung in Bezug auf die Verarbeitungslinie, insbesondere innerhalb der Verarbeitungskammer, bewegen.

4. Bearbeitungslinie nach Anspruch 1, *wobei* die Schlitten (9, 10) so konfiguriert sind, dass sie sich in Bezug auf die Verarbeitungslinie, insbesondere innerhalb der Verarbeitungskammer, in entgegengesetzten Richtungen bewegen.

5. Bearbeitungslinie nach Anspruch 1, ***dadurch gekennzeichnet, dass*** die Schlitten (9, 10) am Ende der Bearbeitungslinie umschaltbar oder verschiebbar oder austauschbar oder in eine Gegenbahn verfahrbar sind, ohne der Atmosphäre ausgesetzt zu sein.

6. Bearbeitungslinie nach Anspruch 5, wobei die Gegenbahn eine Bahn ist, entlang der die Wagen einzeln in eine erste Richtung bewegt werden, bevor sie umgeschaltet oder verschoben oder ausgetauscht oder angefahren werden.

7. Bearbeitungslinie nach Anspruch 5, wobei die Gegenbahn parallel zu einer ersten Bewegungsrichtung der Schlitten (9, 10) ausgerichtet ist

8. Bearbeitungslinie nach Anspruch 5, wobei die erste Bewegungsrichtung des ersten Wagens die Gegenbahn für den zweiten Wagen ist und umgekehrt.

9. Bearbeitungslinie nach Anspruch 1, *wobei* die Trommeln auf dem Wagen (9) und dem zusätzlichen zweiten Wagen (10) so konfiguriert sind, dass sie sich in die gleiche oder entgegengesetzte Richtung drehen.

## Revendications

1. Ligne de traitement pour l'application du revêtement d'une couche mince avec au minimum un sas, avec au minimum une chambre tampon et avec au minimum une chambre de traitement contenant des dispositifs technologiques pour l'application d'un matériau stratifié et pour le traitement supplémentaire de la couche appliquée ainsi que deux supports de substrat (1) portant des substrats où les supports de substrat sont disposés respectivement sur un véhicule (9,10) et sont formés de sorte à traverser les chambres à titre parallèle et côté à côte où au minimum un dispositif technologique est formé pour séparer le matériau de la surface du substrat et qu'au minimum un dispositif supplémentaire est formé de sorte à traiter d'avantage le matériau séparé sur la surface du substrat et chez lequel un système de transport est exécuté au niveau de chaque support de substrat (1) sous forme d'un barillet rotatif,
Où les chariots (9,10) présentent respectivement un barillet parallèle orienté l'un vers l'autre et au-dessus le barillet fixé rotatif et que les barillets disposés sur les chariots (9,10) sont installés à titre coaxial en direction du mouvement du chariot et sont formés de sorte qu'ils sont rotatifs avec une vitesse d'angle constante et que les chariots (9,10) sont déplaçables en avant avec une vitesse constante linéaire où le dispositif technologique se situe entre les barillets pour l'application du matériau de la couche et le dispositif technologique se situe entre les barillets pour le traitement supplémentaire de la couche appliquée.

2. Ligne de traitement selon la revendication 1 où les barillets sont configurés de sorte qu'ils pivotent l'orientation du substrat (3) en relation avec la surface extérieure des barillets dans un positionnement ou dans plusieurs positionnements du véhicule tout au long de la ligne de traitement.

3. Ligne de traitement selon la revendication 1 où les chariots (9,10) sont configurés de sorte qu'ils se déplacent dans une direction en relation avec la ligne de traitement, en particulier à l'intérieur de la chambre de traitement.

4. Ligne de traitement selon la revendication 1 où les chariots (9,10) sont configurés de sorte qu'ils se déplacent en relation avec la ligne de traitement, en particulier à l'intérieur de la chambre de traitement et ce dans des directions opposées.

5. Ligne de traitement selon la revendication 1 est **caractérisée** de sorte que les chariots (9,10) sont commutables ou déplaçables ou interchangeables à la fin de la ligne de traitement ou sont mobiles dans une contre-dent sans être exposés à l'atmosphère.

6. Ligne de traitement selon la revendication 5 où la contre-dent présente une bande tout au long de laquelle les véhicules sont déplacés à titre séparé dans une première direction avant qu'ils ne soient commutés ou déplacés ou interchangés ou percutés.

7. Ligne de traitement selon la revendication 5 où la contre-dent est orientée à titre parallèle vers la première direction du mouvement des chariots (9,10).

8. Ligne de traitement selon la revendication 5 où la première direction du mouvement du premier véhicule présente la contre-dent pour le deuxième véhicule et vice versa.

9. Ligne de traitement selon la revendication 1 où les barillets sont configurés sur le véhicule (9) et sur le deuxième véhicule supplémentaire (10) de sorte qu'ils pivotent dans la même direction ou dans la direction opposée.
